# EUROPEAN PATENT APPLICATION

(11) **EP 1 647 829 A1**
(43) Date of publication of application: **19.04.2006**
(21) Application number: 04745954.0
(22) Date of filing: 09.06.2004
(51) Int. Cl.: G01R 33/02

(54) **ANTENNA FOR DETECTING MAGNETIC FIELD, AND GATE FOR DETECTING DETECTION TAG EMPLOYING THE ANTENNA**

(30) Priority: 18.07.2003 JP 2003199323
(71) Applicant: Lintec Corporation, Tokyo 173-0001 (JP); CDN Corporation, Miyazaki-shi, Miyazaki 880-0934 (JP)
(72) Inventor: MATSUI, Kunihiko, Higashimorokata-gun, Miyazaki 880-1302 (JP); HIBARINO, Toshihisa, Miyazaki-shi, Miyazaki 880-0864 (JP); MOROYA, Tetsuo, Itabashi-ku, Tokyo 173-0001 (JP); OISHI, Hiroshi c/o Lintec Corporation, Chiyoda-ku, Tokyo 101-0044 (JP)
(74) Representative: Hengelhaupt, Jürgen
(86) International application number: PCT/JP2004/008406
(87) International publication number: WO 2005/008267

(57) **Abstract**

The present invention discloses:
an antenna for detecting a magnetic field, wherein a plurality of loop antennas wound in opposite directions are connected in series and placed in a plane,
a magnetic field detector comprising a plurality of the above antennas for detecting a magnetic field and an output circuit for taking out a differential output between the outputs of the plurality of antennas, and
a gate for detecting detection tag comprising the above magnetic field detector and a coil for magnetic field generation.

## Description

### Technical Field

The present invention relates to an antenna for detecting a magnetic field which detects a detection tag or the like by detecting a change in magnetic field, a magnetic field detector employing the antenna, and a gate for detecting detection tag. More particularly, the present invention relates to an antenna for detecting a magnetic field which is constituted by a plurality of loop antennas and gives a high signal/noise ratio (S/N ratio), a magnetic field detector employing the antenna, and a gate for detecting detection tag.

### Background Art

Detection tags employing a magnetic field as a detection means are known. They are adhered to goods, etc., are carried with the goods and, when passing through particular gates, are detected by gates; thereby, the circulation of goods is controlled and the theft of goods is prevented. (Claim 1 of JP 1994-342065A)

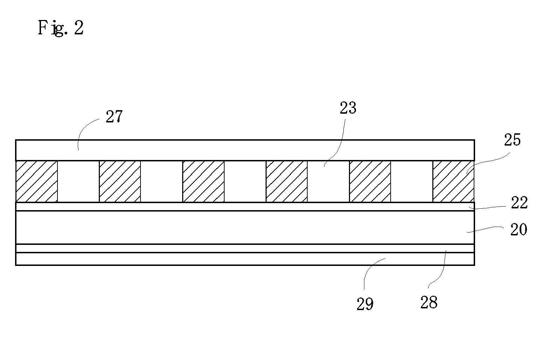

Fig. 2 shows an example of conventional detection tag. In Fig. 2, 20 is a soft magnetic substance layer containing cobalt, etc. On the upper side of the soft magnetic substance layer 20 is laminated, via a polyester-based adhesive layer 22, a ferromagnetic substance layer 25 having a large number of through-holes 23 formed therein. The ferromagnetic substance layer 25 contains a ferromagnetic substance element(s) such as nickel or (and) the like. On the upper side of the ferromagnetic substance layer 25 is adhered a protective layer 27 made of wood free paper or a resin film.

On the lower side of the soft magnetic substance layer 20 is adhered a release liner 29 via a pressure-sensitive adhesive layer 28.

In using this detection tag, the release liner 29 is peeled and the release liner-removed detection tag is adhered to goods or the like to be controlled.

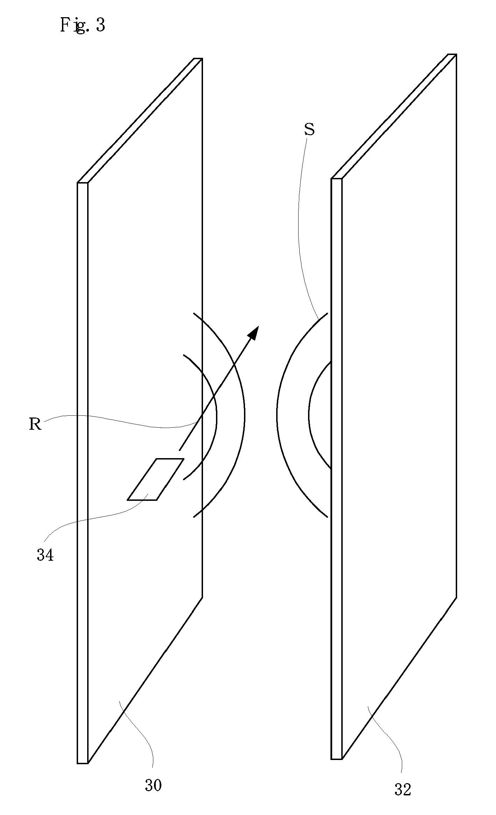

Fig. 3 shows gates 30 and 32 which detect a detection tag. An alternating magnetic field S is formed between the gates 30 and 32. To the gates 30 and 32 is fitted a detector (not shown) for detecting a magnetic field intensity, and the detector detects a magnetic field intensity between the gates 30 and 32. Incidentally, 34 is a detection tag. When the detection tag 34 moves between the gates 30 and 32 to a direction indicated by an arrow R, in a state fitted to goods, etc. (not shown), the magnetic field S formed between the gates 30 and 32 is distorted. By detecting this distortion of the magnetic field S employing the detector, the passing of the detection tag 34 between the gates 30 and 32 is detected.

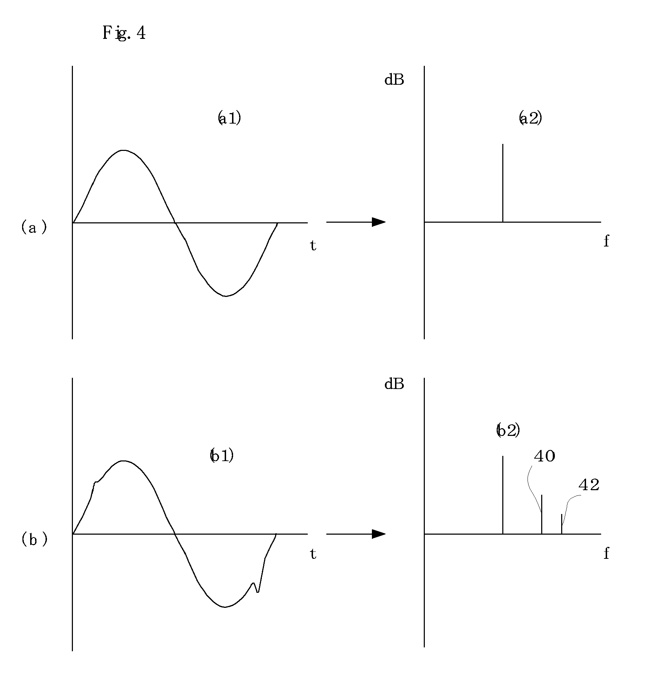

Fig. 4 shows an example of method for specifically detecting the distortion of magnetic field. In Fig. 4, (a1) shows the waveform of an alternating magnetic field of particular frequency formed between the gates 30 and 32. By converting the axis t of time into an axis f of frequency using a known simple mathematical means, this waveform of alternating magnetic field is converted into a waveform shown in (a2).

In Fig. 4, (b1) shows the waveform of an alternating magnetic field which has been distorted by the passing of detection tag 34 between gates 30 and 32. By subjecting this distorted waveform to the same axis conversion as above, a waveform shown in (b2) is obtained. In the waveform of (b2), there are seen harmonics 40 and 42 caused by the distortion of an alternating magnetic field. By detecting the presence of these harmonics, the passing fact of detection tag 34 between gates 30 and 32 can be confirmed.

For example, when the goods or the like purchased normally is in a state that it can be carried out, the detection tag 34 adhered to the goods or the like is deactivated beforehand. Owing to this deactivation operation, there occurs no distortion of magnetic field when the detection tag 34 adhered to the goods or the like is passed between gates 30 and 32. Consequently, the detection tag adhered to the goods or the like is not detected during the passing between these gates and the goods or the like is carried outside.

Meanwhile, when the goods or the like is carried out illegally, the detection tag 34 adhered thereto is in a state not deactivated. Therefore, when the goods or the like containing the detection tag 34 not deactivated is passed between gates 30 and 32, distortion of magnetic field takes place. Detection of this distortion of magnetic field can detect illegal take-out of goods or the like.

Deactivation of detection tag can be achieved by magnetizing the ferromagnetic substance layer 25 of detection tag shown in Fig. 2, using a deactivation machine.

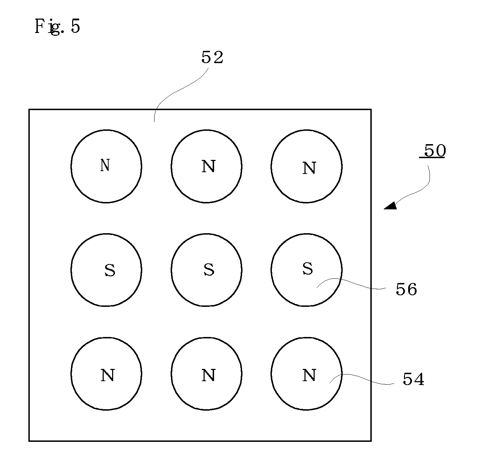

Fig. 5 shows a deactivation machine used conventionally. This deactivation machine 50 comprises cylindrical permanent magnets of 12 mm in diameter arranged at intervals of about 10 mm on a support 52. The permanent magnets are arranged so that an N pole 54 and an S pole 56 appear alternately.

When the detection tag shown in Fig. 2 touches on the upper surface of the deactivation machine 50, the ferromagnetic substance layer 25 is magnetized and thereby the detection tag is deactivated.

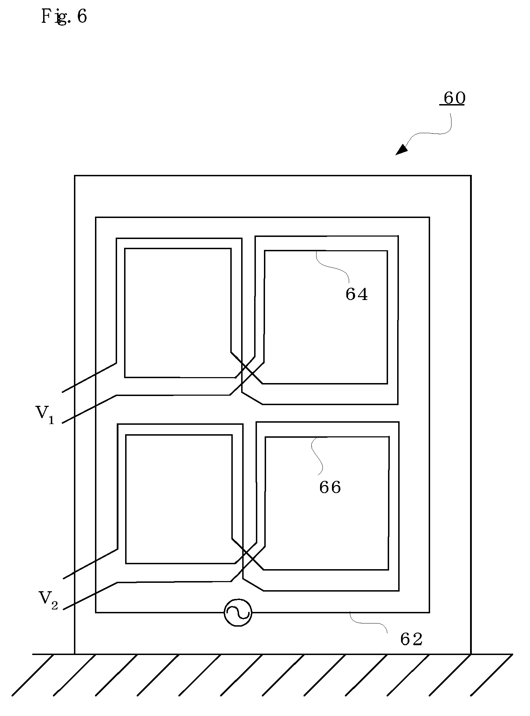

Fig. 6 shows a conventional gate 60. A loop-shaped coil 62 for magnetic field generation is formed along the inner periphery of the gate. When an AC power of given frequency is supplied to the coil 62 for magnetic field generation, an alternating magnetic field is generated in a direction normal to the coil 62 for magnetic field generation.

Inside the coil 62 for magnetic field generation are arranged, in upper and lower lines, a first antenna 64 for detecting a magnetic field and a second antenna 66 for detecting a magnetic field, both formed by winding an electric wire in an approximate 8 shape. Since the antennas 64 and 66 are formed each in a large, approximate 8 shape, the voltage induced by the magnetic field generated by the coil 62 for magnetic field generation is made small and further the detection area for detection tag is made large.

Since the formation of each antennas 64 and 66 are made in a large 8 shape, the antennas 64 and 66 detect an external noise which is generated in a large area. Consequently, there is a problem that the signal of small detection tag may not be detected.

### Disclosure of the Invention

The present inventor made a study in order to alleviate the above-mentioned problem. As a result, the present inventor thought of an idea of connecting in series a plurality of relatively small loop antennas wound in opposite directions and placing them in a plane. This antenna has been found to be able to cancel the generated external noise between the individual loop antennas while promising a large detection area and resultantly be able to detect a detection tag at a high S/N ratio. This finding has led to the completion of the present invention.

Hence, the present invention aims at solving the above-mentioned problems and providing an antenna of high S/N ratio for detecting a magnetic field, a magnetic field detector employing the antenna, and a gate for detecting detection tag.

The present invention which has achieved the above aim, is as described below.
[1] An antenna for detecting a magnetic field, wherein a plurality of loop antennas wound in opposite directions are connected in series and placed in a plane.
[2] A magnetic field detector comprising a plurality of antennas for detecting a magnetic field each set forth in [1] and an output circuit for taking out a differential output between the outputs of the plurality of antennas for detecting a magnetic field.
[3] A magnetic field detector according to [2], wherein the output circuit is a differential amplifier circuit.
[4] A magnetic field detector according to [2], wherein the output circuit is a circuit formed by connecting the plurality of antennas for detecting a magnetic field in series so that the polarities of antennas become opposite from each other.
[5] A gate for detecting detection tag comprising a coil for magnetic field generation and a magnetic field detector set forth in [2].
[6] A gate for detecting detection tag according to [5], wherein the distance between each loop antenna and the coil for magnetic field generation is 10 to 40 cm.

In the antenna for detecting a magnetic field according to the present invention, a plurality of loop antennas (which are small as compared with conventional 8-shaped antenna) are arranged in a state dispersed in a large area and are connected to each other; therefore, a magnetic field can be detected in a large area. In this case, each two adjacent loop antennas are reversed in the direction in which the electric wire constituting each loop antenna is wound. With this way of winding, the magnetic flux directions of two adjacent loop antennas are reversed, which cancels the external noise generated and consequently heightens the ratio of detection of target signal, resulting in a high S/N ratio.

Further, in the case of conventional 8-shaped antenna, the external noise generated in the vicinity of the antenna center (where intersection of electric wire takes place) is cancelled owing to the unique structure of the antenna; however, the signal generated is cancelled as well. Furthermore, in the 8-shaped antenna, the area in which the external noise is cancelled, is smaller than the area which is affected by the noise; therefore, the 8-shaped antenna gives a low S/N ratio.

In contrast, the present invention antenna is constituted by relatively small loop antennas; therefore, the noise generated can be cancelled and signal cancellation can be prevented by arranging individual loop antennas apart from each other. In other words, it is easy to control a balance between the adverse effect of noise and the reception of signal. Reduction in the voltage (noise) induced by the coil for magnetic field generation is possible even with the 8-shaped antenna and there is a certain effect in the center of the antenna. When a plurality of small loop antennas are arranged as in the present invention, it is possible to arrange them apart from each other and accordingly there can be obtained a S/N ratio higher than in the 8-shaped antenna.

In the conventional large 8-shaped coil, a noise of large area is detected and, therefore, there is a case in which cancellation of noise by the large antennas is difficult. However, when relatively small coils are used as in the present invention, a probability of noise cancellation by coils is high.

### Brief Description of the Drawings

Fig. 1 is a view showing an example of a constitution of the gate for detecting detection tag of the present invention, wherein (a) shows a constitution of the gate and (b) and (c) show each a specific example of the output circuit 116 of the gate.
Fig. 2 is a sectional view showing an example of the constitution of detection tag.
Fig. 3 is a view showing a method for detection of detection tag.
Fig. 4 is a view showing the principle of detection of detection tag. (a) shows the waveform of an alternating magnetic field generated between gates, and (b) shows the waveform of an alternating magnetic field when a detection tag has been detected.
Fig. 5 is a plan view showing an example of the constitution of conventional deactivation machine.
Fig. 6 is a view showing an example of a conventional gate for detecting detection tag.

20 is a soft magnetic substance layer; 22 is an adhesive layer; 23 is a through-hole; 25 is a ferromagnetic substance layer; 27 is a protective layer; 28 is a pressure-sensitive adhesive layer; 29 is a release liner; 30 and 32 are each a gate; 34 is a detection tag; S is a magnetic field; 40 and 42 are each a harmonic; 50 is a deactivation machine; 52 is a support; 54 is an N pole; 56 is an S pole; 60 is a conventional gate; 62 is a coil for magnetic field generation; 64 is a first antenna for detecting a magnetic field; 66 is a second antenna for detecting a magnetic field; 100 is a gate for detecting detection tag; 102 is a floor; 104 is a coil for magnetic field generation; 106, 108, 120 and 122 are each a loop antenna; 110 is a first antenna for detecting a magnetic field; 112 and 124 are each a leader line for terminal; 114 and 126 are each one end; 116 is an output circuit; T is a distance; and 118 is a second antenna for detecting a magnetic field.

### Best Mode for Carrying Out the Invention

An embodiment of the present invention is described in detail below with reference to the accompanying drawings.

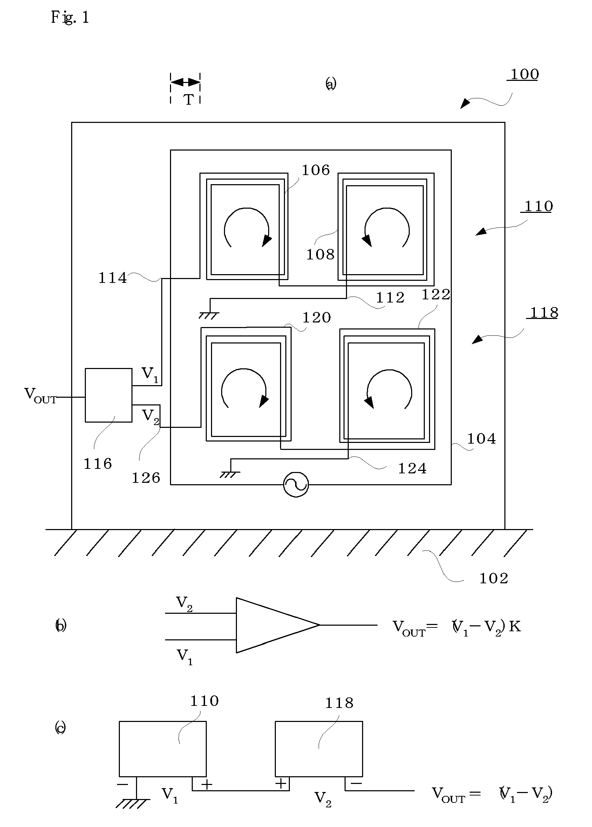

In Fig. 1, 100 is a gate for detecting detection tag of the present invention and it is fixed on the floor 102 of building, or the like. Inside the gate 100 is fitted a coil 104 for magnetic field generation, constituted by loop coils wound along the inner periphery of the gate 100. When an AC power of given frequency is supplied to the coil 104, an alternating magnetic field of given frequency is induced by the coil 104.

In the same plane as that formed by the coil 104 for magnetic field generation, a plurality (two in Fig. 1) of loop antennas 106 and 108 connected in series are placed inside of the coil 104. These loop antennas 106 and 108 constitute a first antenna 110 for detecting a magnetic field. In the loop antenna 106 and the loop antenna 108, an electric wire is wound in opposite directions. A leader line 112 for the terminal of the loop antenna 108 is earthed and one end 114 of the loop antenna 106 is connected to the input side of an output circuit 116.

As to the distance T between the loop antenna 106 or the loop antenna 108 and the coil 104 for magnetic field generation, there is no particular restriction. However, the distance is preferably about 10 to 40 cm.

Below the first antenna 110 for detecting a magnetic field is placed a second antenna 118 for detecting a magnetic field, having the same constitution as that of the first antenna 110 for detecting a magnetic field. That is, loop antennas 120 and 122 wound in opposite directions are connected in series and a leader line 124 for the terminal of the loop antenna 122 is earthed. One end 126 of the loop antenna 118 is connected to the input side of the output circuit 116.

The output circuit 116 is constituted so that the voltage difference between the output of the first antenna 110 for detecting a magnetic field and the output of the second antenna 118 for detecting a magnetic field can be taken out.

An example of the output circuit 116 is shown in Fig. 1(b). In this example, the output circuit 116 is constituted as a differential amplification circuit, and this circuit outputs an amplified voltage difference between the output of the first antenna 110 for detecting a magnetic field and the output of the second antenna 118 for detecting a magnetic field while the noises detected by the two antennas being cancelled. Incidentally, V₁ and V₂ are output voltages of the antennas 110 and 118 for detecting a magnetic field; Vₒᵤₜ is an output voltage of the output circuit 116; and K is an amplification ratio.

Another example of the output circuit 116 is shown in Fig. 1(c). In this circuit, the first antenna 110 for detecting a magnetic field and the second antenna 118 for detecting a magnetic field are connected in series in such a way that the output polarities of the first antenna 110 for detecting a magnetic field and the second antenna 118 for detecting a magnetic field become opposite from each other. This circuit acts in the same manner as the differential amplification circuit.

Incidentally, in the above explanation, the antennas 110 and 118 both for detecting a magnetic field have been constituted each by two loop antennas; however, more than two loop antennas may be combined. In this case, each antenna for detecting a magnetic field is preferred to be constituted by an even number of loop antennas, from the standpoint of noise cancellation. Further, it is possible to use more than two antennas for detecting a magnetic field. It is preferred to use an even number of antennas for detecting a magnetic field, from the standpoint of efficient noise cancellation. In the above explanation, the antennas for detecting a magnetic field have been placed inside the coil for magnetic field generation; however, they can be placed in any desired site as long as the aim of the present invention is not impaired.

### Examples

The present invention is described more specifically below by way of Example and Comparative Example.

### Example 1

A gate shown in Fig. 1 was produced. An electric wire was wound in a loop shape of 120 cm in length and 60 cm in width to form a coil 104 for magnetic field generation. The number of turns of the coil 104 for magnetic field generation was 100. In the upper half of the loop plane formed by the coil 104 for magnetic field generation, two loop antennas 106 and 108 wound in opposite directions were connected in series. Each loop antenna was 40 cm in length and 10 cm in width and its number of turns was 80. The distance between the two loop antennas 106 and 108 was 14 cm, and the distance T between the coil 104 for magnetic field generation and the loop antenna 106 or 108 was 23 cm.

Loop antennas 120 and 122 having the same constitution as the loop antennas 106 and 108 were fitted below the loop antennas 106 and 108. The distance between the two loop antennas 120 and 122 and the distance between the coil 104 for magnetic field generation and the loop antenna 120 or 122 were the same as above. The loop antennas 106, 108, 120 and 122 and the coil 104 for magnetic field generation were placed in the same plane.

An alternate current of 300 Hz and 100 V was supplied to the coil 104 for magnetic field generation.

The outputs of the above two antennas 110 and 118 for detecting a magnetic field were sent to an output circuit 116 [constituted as a differential amplifier circuit (b)] and differential amplification was made. The differential amplifier output was subjected to A/D conversion and then sent to a personal computer (not shown) for data processing regarding the conversion of time axis to frequency axis. The data obtained was stored in a memory. With respect to the detection frequency, the main frequency was 300 Hz. Incidentally, the amplification ratio K of the differential amplifier circuit was 10,000.

An electromagnetically responding detection tag shown in Fig. 2 [EH-026 (trade name) produced by LINTEC Corporation, length = 26 mm, width = 16 , thickness = 240 µm] was passed along the above-produced gate in a state not deactivated. While the distance between the gate surface and the passing detection tag was maintained at 10 cm, total 100 tags were passed one by one horizontally at a speed of 0.5 m/sec.

As a result, the gate could detect passing of all of the 100 tags.

Then, 100 detection tags deactivated by a deactivation machine were passed along the gate under the same conditions as above. As a result, none of the tags was detected.

### Comparative Example 1

A gate shown in Fig. 6 was produced. The same electric wire of the same length as in Example 1 was used for formation of a coil 62 for magnetic field generation, an 8-shaped first antenna 64 for detecting a magnetic field and an 8-shaped second antenna 66 for detecting a magnetic field. The distance between the coil 62 for magnetic field generation and the 8-shaped first antenna 64 for detecting a magnetic field or the 8-shaped second antenna 66 for detecting a magnetic field was 10 cm. The alternate current supplied to the coil for magnetic field generation was the same as in Example 1. Outputs V₁ and V₂ were subjected to A/D conversion and then sent to a personal computer, and detection of detection tag was conducted in the same manner as in Example 1. As a result, only 29 detection tags of total 100 detection tags were detected for passing.

Then, 100 detection tags deactivated by a deactivation machine were passed along the gate under the same conditions as above. As a result, 34 tags were detected. It became clear from this result that the gate of Comparative Example was easily affected by noise.

## Claims

1. An antenna for detecting a magnetic field, wherein a plurality of loop antennas wound in opposite directions are connected in series and placed in a plane.

2. A magnetic field detector comprising a plurality of antennas for detecting a magnetic field each set forth in Claim 1 and an output circuit for taking out a differential output between the outputs of the plurality of the antennas for detecting a magnetic field.

3. A magnetic field detector according to Claim 2, wherein the output circuit is a differential amplifier circuit.

4. A magnetic field detector according to Claim 2, wherein the output circuit is a circuit formed by connecting the plurality of antennas for detecting a magnetic field in series so that the polarities of antennas become opposite from each other.

5. A gate for detecting detection tag comprising a coil for magnetic field generation and a magnetic field detector set forth in Claim 2.

6. A gate for detecting detection tag according to Claim 5, wherein the distance between each loop antenna and the coil for magnetic field generation is 10 to 40 cm.
